# EUROPEAN PATENT APPLICATION

(11) **EP 4 787 637 A1**
(43) Date of publication of application: **05.08.2026**
(21) Application number: 24872057.5
(22) Date of filing: 20.09.2024
(51) Int. Cl.: H01S 5/02224, H01S 5/02257

(54) **LIGHT-EMITTING DEVICE**

(30) Priority: 26.09.2023 JP 2023161821
(71) Applicant: Kyocera Corporation, Kyoto-shi, Kyoto 612-8501 (JP)
(72) Inventor: NIINO, Noritaka, Kyoto-shi, Kyoto 612-8501 (JP)
(74) Representative: Viering, Jentschura & Partner mbB Patent- und Rechtsanwälte
(86) International application number: PCT/JP2024/033581
(87) International publication number: WO 2025/070266

(57) **Abstract**

A light-emitting device includes a semiconductor laser element containing gallium nitride, a housing including a recess in which the semiconductor laser element is located, a lid sealing an open surface of the recess of the housing, and a first bonding material bonding the lid and the housing. A member serving as a bottom surface of the recess is a heat transfer body. Oxygen is contained in the recess. The first bonding material melts at not more than 300°C in an oxygen-containing atmosphere. The light-emitting device may further include a heat-dissipating body bonded to a lower surface of the housing, and a second bonding material bonding the heat-dissipating body and the housing. The second bonding material may melt at a temperature lower than a temperature at which the first bonding material melts.

## Description

### TECHNICAL FIELD

The present disclosure relates to a light-emitting device.

### BACKGROUND OF INVENTION

A known light-emitting device includes a laser light source sealed inside a package, and stably outputs light emitted from the laser light source. In International Publication No. WO 2020/175303, light emitted from a light source in a direction along a bottom surface of a package is reflected upward by a mirror and is output. In this case, a gallium nitride (GaN)-based laser diode is known to be less likely to undergo progression of deterioration when oxygen is contained inside a package.

### SUMMARY

In an aspect of the present disclosure,
[1] A light-emitting device includes a semiconductor laser element containing gallium nitride, a housing including a recess in which the semiconductor laser element is located, a lid sealing an open surface of the recess of the housing, and a first bonding material bonding the lid and the housing. A member serving as a bottom surface of the recess is a heat transfer body. Oxygen is contained in the recess. The first bonding material melts at not more than 300°C in an oxygen-containing atmosphere.
[2] The light-emitting device described in [1] further includes a heat-dissipating body bonded to a lower surface of the housing, and a second bonding material bonding the heat-dissipating body and the housing. The second bonding material melts at a temperature lower than a temperature at which the first bonding material melts.
[3] The light-emitting device described in [1] further includes a heat-dissipating body bonded to a lower surface of the housing, and a second bonding material bonding the heat-dissipating body and the housing. The second bonding material melts at not more than 300°C and at a temperature higher than a temperature at which the first bonding material melts.
[4] In the light-emitting device described in [2] or [3], the heat-dissipating body includes a metal-core printed circuit board.
[5] In the light-emitting device described in [2] or [3], each of the first bonding material and the second bonding material is tin-silver-nickel solder, tin-silver-copper solder, tin-zinc solder, or tin-bismuth solder.
[6] In the light-emitting device described in any one of [1] to [5], the heat transfer body includes a wiring line electrically connected to the semiconductor laser element.
[7] In the light-emitting device described in any one of [1] to [6], the semiconductor laser element is bonded to the recess with a conductive resin bonding material containing silver, copper, or gold.
[8] In the light-emitting device described in [2] or [3], the semiconductor laser element is bonded to the recess with a third bonding material. A melting temperature of the third bonding material is higher than melting temperatures of the first bonding material and the second bonding material.
[9] In the light-emitting device described in [8], the first bonding material, the second bonding material, and the third bonding material differ from one another in their components at least in part.

### BRIEF DESCRIPTION OF THE DRAWINGS

FIG. 1A is an overall perspective view illustrating the structure of a light-emitting device according to a first embodiment.
FIG. 1B is a cross-sectional view illustrating the structure of the light-emitting device according to the first embodiment.
FIG. 2A is a cross-sectional view illustrating Variation 1 of the light-emitting device according to the first embodiment.
FIG. 2B is a cross-sectional view illustrating Variation 2 of the light-emitting device according to the first embodiment.
FIG. 3 is a cross-sectional view of a light-emitting device according to a second embodiment.

### DESCRIPTION OF EMBODIMENTS

Embodiments are described below with reference to the drawings.

### [First Embodiment]

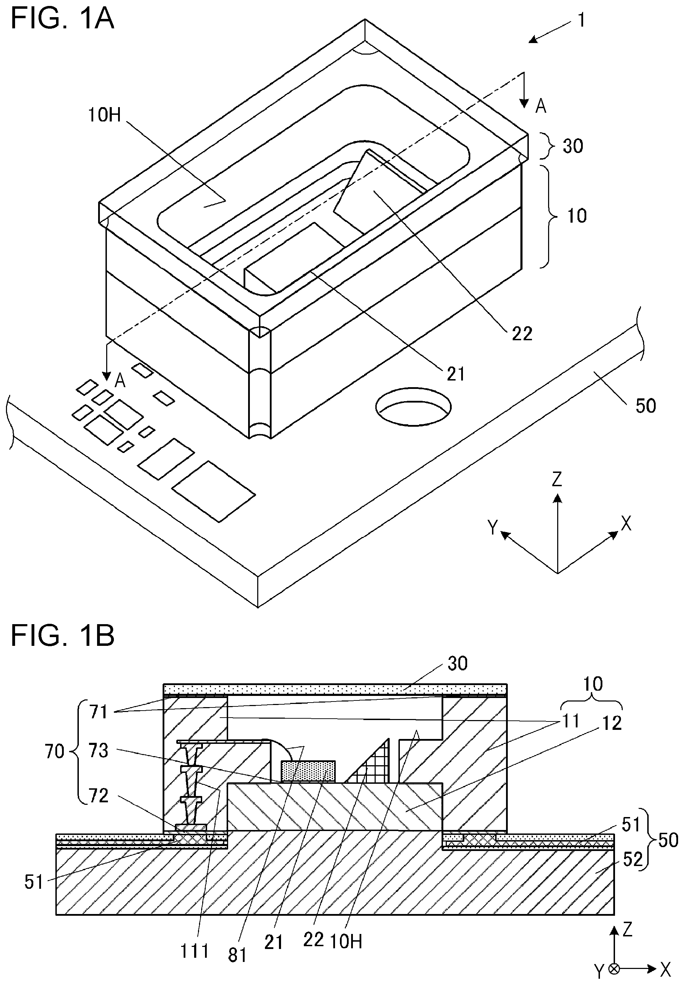

FIGs. 1A and 1B are views illustrating a structure of a light-emitting device 1 of a first embodiment. FIG. 1A is an overall perspective view, and FIG. 1B is a cross-sectional view taken along a section line AA in FIG. 1A.

The light-emitting device 1 includes a package 10, a lid 30, a substrate 50, a light-emitting element 21, and a reflector 22.

The package 10 is a housing including a recess 10H near a center of a +Z-side surface that is opposite to the substrate 50 in a Z direction perpendicular to an upper surface of the substrate 50, the upper surface serving as a bonding surface of the package 10. The package 10 accommodates the light-emitting element 21 and the reflector 22 in the recess 10H. The longitudinal direction of the package 10 is defined as an X-axis direction, and a Y-axis is defined as being perpendicular to the X-axis and a Z-axis.

The package 10 includes a frame body 11 that surrounds a side surface of the recess 10H, and a bottom plate 12 that closes a lower end of the frame body 11, the lower end being the -Z-side end, and that defines a bottom surface of the recess 10H. The light-emitting element 21 and the reflector 22 are located on the bottom plate 12. The light-emitting element 21 is bonded to the bottom plate 12 by a bonding member 73, which is an example of a third bonding material of the present disclosure.

The bottom plate 12 is a heat transfer body having a higher thermal conductivity than that of the frame body 11 in at least one direction. The bottom plate 12 may have a higher thermal conductivity than the frame body 11 in, for example, the Z direction directed from one surface of the package 10 toward the other surface. The thermal conductivity of the bottom plate 12 may be, for example, 90 W/m·K or more, 120 W/m·K or more, 200 W/m·K or more, or 300 W/m·K or more. A material having a high thermal conductivity, such as a metal or ceramic, may be used as a material of the bottom plate 12. The metal may be, for example, copper, aluminum, or an alloy containing at least one of these. The ceramic may include, in addition to a polycrystalline inorganic material, a single-crystal inorganic material. In an embodiment, the thermal conductivity of the bottom plate 12 may be higher than the thermal conductivity of the frame body 11 in any direction.

The frame body 11 may be made of ceramic. The frame body 11 is made of, for example, alumina, aluminum nitride, silicon nitride, zirconia, or resin. A wiring line 111 is disposed in the frame body 11. The wiring line 111 may include a via conductor or the like. One end of the wiring line 111 is disposed in the recess 10H of the frame body 11 and is connected to an electrode. When the electrode and the light-emitting element 21 are electrically connected, a driving signal is transmitted to the light-emitting element 21. A connection between the electrode and the light-emitting element 21 may be, for example, a bonding wire 81.

The light-emitting element 21 is a laser diode (LD). The LD is a semiconductor laser element (GaN-based LD) including a crystal containing gallium nitride (GaN), and may emit, for example, blue light. Here, the light-emitting element 21 may be positioned on an inner surface of the recess 10H, for example, on an inner bottom surface, and may be an edge-emitting type that emits light in a +X direction along the bottom surface.

The reflector 22 is a flip-up mirror and reflects light emitted from the light-emitting element 21 to change the direction of the light upward along the Z-axis direction.

A plurality of light-emitting elements 21 and a plurality of reflectors 22 may be positioned in the recess 10H. A common reflector 22 may be used for the plurality of light-emitting elements 21.

The lid 30 is positioned above the package 10, that is, on the +Z side. The lid 30 is bonded to an upper surface of the package 10 by a bonding member 71 to seal an open surface of the recess 10H. The bonding member 71 is an example of a first bonding material in the present disclosure. A gas inside the sealed recess 10H contains oxygen. The base may be at atmospheric pressure. The lid 30 includes a light-transmissive portion. The lid 30 is, for example, an airtight light-transmissive member, and may be made of, for example, borosilicate glass or sapphire glass. A surface of the lid 30 may be provided with an antireflection coating (AR coating). Light emitted from the light-emitting element 21 and directed in the +Z direction by the reflector 22 passes through the lid 30 and is emitted outside the light-emitting device 1.

The package 10 may be a surface-mount type. In the surface-mount-type package 10, a lower surface, which is a -Z-side surface thereof, is bonded to the substrate 50. The substrate 50 may be a metal-core printed circuit board (MCPCB). The substrate 50 is bonded to a lower end surface of the frame body 11 by a bonding member 72. The bonding member 72 is an example of a second bonding material of the present disclosure. The bonding member 72 is a conductive bonding member, and the wiring line 111 in the frame body 11 and a wiring line 51 on the substrate 50 are electrically connected. A base 52 of the substrate 50 is a heat-dissipating body with a high thermal conductivity. The base 52 is bonded to the bottom plate 12, and quickly dissipates, to the outside, heat emitted by the light-emitting element 21 via the bottom plate 12. The base 52 may be made of a ceramic or metal. When the base 52 is made of a metal, the base 52 is insulated from the wiring line 51. The base 52 and the bottom plate 12 may be made of the same material. Note that a plurality of packages 10 each including the light-emitting element 21 and the reflector 22 may be bonded to the substrate 50.

A bonding member 70 will be described. A GaN-based LD is known to undergo deterioration particularly in an upper half of a 300°C range. Therefore, each part of the light-emitting device 1 including the light-emitting element 21 needs to be bonded at a temperature in a lower half of the 300°C range or lower. In particular, the bonding members 71 and 72 preferably melt at not more than 300°C. The progression of deterioration of a GaN-based LD is known to be reduced by operating it in the presence of oxygen. Therefore, at the time of sealing, here, the bonding member 71 used at the time of bonding the lid 30 needs to enable bonding of the lid 30 in an oxygen-containing atmosphere while satisfying the above temperature conditions.

In the light-emitting device 1 of the present embodiment, after the light-emitting element 21 and the reflector 22 are bonded to the package 10 by primary mounting, the lid 30 is bonded for sealing. The package 10 is bonded to the substrate 50 by secondary mounting. Therefore, the bonding of the light-emitting element 21 and the reflector 22 can be performed at about 300°C, and the presence or absence of oxygen during bonding does not need to be considered. That is, a melting temperature of the bonding member 73 may be higher than those of the bonding members 71 and 72. A common gold-tin (Au-Sn) solder, which contains 80% Au and 20% Sn and has a melting temperature of from 280°C to 300°C, may be used for this bonding. Alternatively, a sintering paste, a flowable conductive resin bonding material, may be used for this bonding. The sintering paste has flowability with particles of a conductive metal, such as silver, copper, or gold, dispersed in a base material, such as a resin and/or a solvent. The sintering paste is cured and bonded by being heated to a temperature of from 200°C to 250°C, and does not remelt even when reheated to the same temperature or higher. Therefore, in this case, a heating temperature of the sintering paste during bonding of the light-emitting element 21 and the reflector 22 may be lower than the melting temperatures of the bonding members 71 and 72.

Bonding of the lid 30 to the package 10 and bonding of the substrate 50 are not particularly limited in order. A bonding member that can seal the lid 30 in the presence of oxygen is, for example, tin-silver-copper (Sn-Ag-Cu) solder (SAC solder), tin-silver-nickel (Sn-Ag-Ni) solder, tin-zinc (Sn-Zn)-based solder, or tin-bismuth (Sn-Bi) solder. A melting temperature of the SAC solder and a melting temperature of the tin-silver-nickel solder are about 230°C. A melting temperature of the tin-zinc-based solder is about 220°C. A melting temperature of the tin-bismuth solder is about 160°C. A magnitude relationship between the melting temperature of the bonding member 71 and the melting temperature of the bonding member 72 depends on which bonding is performed first. When the lid 30 is bonded before bonding to the substrate 50, the SAC solder, the tin-silver-nickel solder, or the tin-zinc solder is used as the bonding member 71 in bonding of the lid 30, and the tin-bismuth solder with a lower melting temperature than that of the bonding member 71 is used as the bonding member 72 in bonding to the substrate 50. When the lid 30 is bonded after bonding to the substrate 50, the tin-bismuth solder is used as the bonding member 71 in bonding of the lid 30, and the SAC solder, the tin-silver-nickel solder, or the tin-zinc solder with a higher melting temperature than that of the bonding member 71 is used as the bonding member 72 in bonding to the substrate 50. As described above, bonding of the lid 30 is performed in the presence of oxygen.

As described above, in the light-emitting device 1, during the secondary mounting using the bonding member 72 and the sealing of the recess 10H using the bonding member 71, a bonding member with a lower melting temperature than that of a bonding member used on a side to be bonded first is used as a bonding member on a side to be bonded later. This can avoid remelting of the bonding member bonded first. The bonding member bonded first includes the bonding member for the light-emitting element 21 and the reflector 22 described above. Bonding can be performed in the presence of oxygen with any of the bonding members described above. Therefore, a gas inside the sealed recess 10H contains oxygen.

Note that solders made of the same components but with different ratios of those components may have different melting temperatures. However, such solders may start to partially melt even at a temperature lower than their melting temperatures. Thus, when secondary mounting and sealing are performed using solders made of the same components but with different ratios of those components, the previously fixed solder may partially melt or soften during subsequent soldering, thereby potentially causing displacement or the like. Therefore, for a combination of the bonding member 71 and the bonding member 72, these members 71 and 72 preferably differ from each other at least in part in their components. In a combination of solders made of different components, a larger difference in melting temperature is more preferred.

When there is a difference in melting temperature and the difference is small, for example, for the SAC solder and the Sn-Zn-based solder, even the solder with the higher melting temperature may soften in some cases. Therefore, for the solders used for sealing and secondary mounting, a combination having a large difference in melting temperature may be preferentially selected.

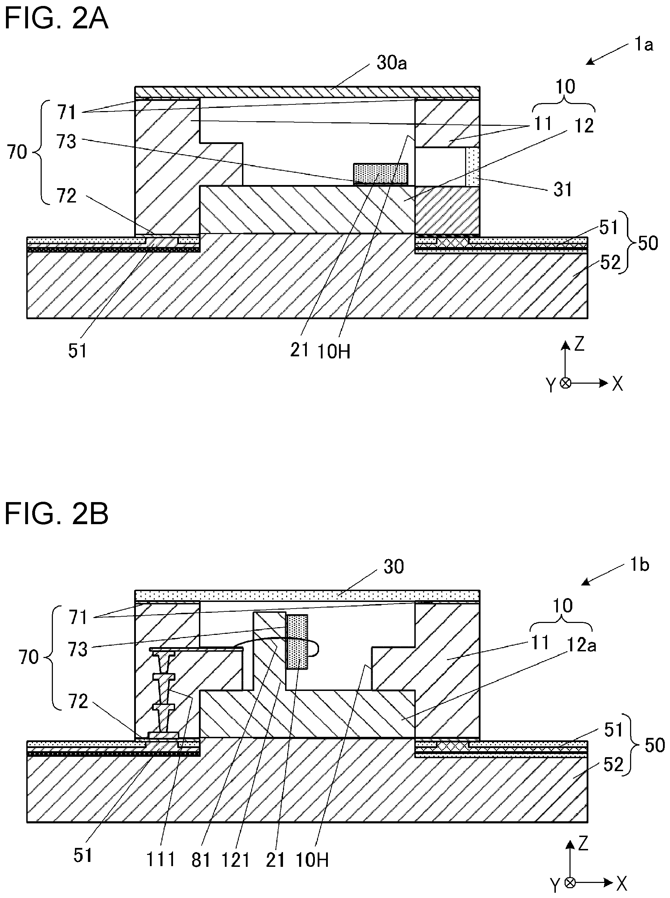

FIGs. 2A and 2B are cross-sectional views illustrating variations of the light-emitting device 1 according to the present embodiment. Each cross section is taken along the section line AA in FIG. 1A described above.

In Variation 1 illustrated in FIG. 2A, a light-emitting device 1a may include a window portion 31 on a side surface on the +X side. The window portion 31 has optical transparency and allows light emitted from the light-emitting element 21 to be emitted outside the light-emitting device 1a as it is. Accordingly, the light-emitting device 1a does not include a reflector. A lid 30a need not have optical transparency. In this case, the lid 30a may be, for example, made of a metal, such as copper, aluminum, or an alloy of these metals. Alternatively, the lid 30a may be made of ceramic.

In Variation 2 illustrated in FIG. 2B, a light-emitting device 1b may include a protruding portion 121 extending from a bottom plate 12a in the +Z direction. The light-emitting element 21 may be located on a side surface of the protruding portion 121, for example, a +X-side surface. Accordingly, an emission direction of light is directed in the +Z direction. As a result, light emitted from the light-emitting element 21 passes through the lid 30 as it is and is emitted outside the light-emitting device 1b. Therefore, the light-emitting device 1b does not include a reflector.

When the light-emitting element 21 is a vertical-cavity surface-emitting laser element (VCSEL), the light-emitting element 21 emits light directly upward and outside the light-emitting device 1b through the lid 30 on the +Z side without using a reflector.

### [Second Embodiment]

In a second embodiment, a light-emitting device 1c will be described.

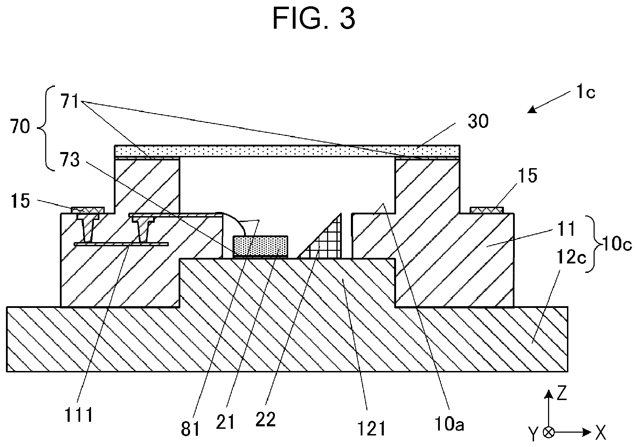

FIG. 3 is a cross-sectional view of the light-emitting device 1c according to the second embodiment. The cross section corresponds to a position of the section line AA in FIG. 1A described above.

In the second embodiment, in the light-emitting device 1c, a portion corresponding to a substrate may be connected to and integrated with a bottom plate 12c of a package 10c. The bottom plate 12c includes a protruding portion 121 fitted into a lower end of the frame body 11. The light-emitting element 21 and the reflector 22 are bonded to an upper surface of the protruding portion 121 via the bonding member 71, the upper surface being a +Z-side surface. That is, the light-emitting device 1c does not need to separately include a substrate such as an MCPCB. When the frame body 11 and the bottom plate 12c are bonded to each other in advance before mounting or sealing, or are integrally formed, high-temperature bonding can be performed in bonding these components without considering deterioration of the light-emitting element 21 or the like. That is, for example, frit glass may be used for the bonding, as well as the gold-tin solder.

Note that, when the bottom plate 12c on which the light-emitting element 21 and the reflector 22 are mounted is bonded after the lid 30 is bonded to seal the recess 10H, a bonding member whose melting temperature in the presence of oxygen is lower than that of the bonding member used for bonding the lid 30 may be used.

The light-emitting element 21 and an electrode (not illustrated) exposed on an inner wall surface of the frame body 11 may be connected using the bonding wire 81. The wiring line 111 in the frame body 11 connects this electrode and a connection electrode 15 located on an outer side surface of the frame body 11. Therefore, the bottom plate 12c need not include a wiring line therein.

During mounting, as the primary mounting, bonding of the light-emitting element 21 and the reflector 22 using the bonding member 73 is performed first, and then sealing is performed by bonding using the bonding member 71 for the lid 30. A gas in the recess 10H contains oxygen. The bonding member 73 may be the gold-tin solder or a sintering paste that is cured upon heating.

As described above, when the gold-tin solder is used as the bonding member 73, the melting temperature of the bonding member 71 is lower than that of the gold-tin solder and not more than 300°C. Bonding using the bonding member 71 can be performed in the presence of oxygen. Therefore, the bonding member 71 may be the SAC solder, gold-zinc solder, gold-bismuth solder, or the like.

With such firm bonding and sealing that reduce the progression of the deterioration of the light-emitting element 21, the oxygen-containing gas can be confined in the recess 10H.

In the present embodiment, as described above, the light-emitting device 1 includes the light-emitting element 21, which is a semiconductor laser element containing gallium nitride, the package 10 including the recess 10H in which the light-emitting element 21 is located, the lid 30 sealing the upper surface of the package 10 on the +Z side, the upper surface being the open surface of the recess 10H, and the bonding member 71 bonding the lid 30 and the package 10. The bottom plates 12 and 12a each defining the bottom surface of the recess 10H are heat transfer bodies. Oxygen is contained in the recess 10H. The bonding member 71 melts at not more than 300°C in an oxygen-containing atmosphere.

As described above, when the recess 10H is sealed, the bonding member 71 that can melt and perform bonding in a temperature range that does not adversely affect the light-emitting element 21 even in an oxygen-containing atmosphere is used. Accordingly, the light-emitting device 1 can appropriately seal the oxygen-containing gas in the recess 10H. Therefore, the light-emitting device 1 can stably operate the GaN-based light-emitting element 21 (LD) with a longer service life.

The light-emitting device 1 may further include the substrate 50 bonded to a lower surface of the package 10 and the bonding member 72 bonding the substrate 50 and the package 10. The bonding member 72 may melt at a temperature lower than a temperature at which the bonding member 71 melts. When, after sealing of the recess 10H, the package 10 is mounted on the substrate 50 in the secondary mounting, the melting temperature of the bonding member 72 is lower than the melting temperature of the bonding member 71. Accordingly, the light-emitting device 1 can be fixed with high accuracy, and the light-emitting element 21 sealed together with oxygen can be stably operated.

Alternatively, the bonding member 72 may melt at not more than 300°C and at a temperature higher than a temperature at which the bonding member 71 melts. After the package 10 is mounted on the substrate 50, the recess 10H may be sealed. Also in this case, the light-emitting device 1 can be fixed with high accuracy, and the light-emitting element 21 sealed together with oxygen can be stably operated.

The substrate 50 may include an MCPCB. Accordingly, the light-emitting element 21 can be easily mounted, and heat generated during operation of the light-emitting element 21 can be rapidly dissipated.

The bonding members 71 and 72 described above may each be any of the tin-silver-nickel solder, the tin-silver-copper solder, the tin-zinc solder, and the tin-bismuth solder. These have various melting temperatures of not more than 300°C in an oxygen-containing atmosphere. Accordingly, bonding using the bonding members 71 and 72 allows the oxygen-containing gas to be sealed in the recess 10H without adversely affecting the light-emitting element 21.

The frame body 11 may include, in an interior thereof or on a surface thereof, the wiring line 111 that electrically connects the light-emitting element 21 and the outside. Accordingly, the light-emitting device 1 can stably supply a required signal to the light-emitting element 21.

The light-emitting element 21 may be bonded to the bottom plate 12 or 12a with a sintering paste containing silver, copper, or gold. The sintering paste has a curing temperature in a lower half of a 200°C range, and does not remelt even when reheated after curing. Accordingly, even when the sintering paste is used for bonding performed prior to other solder bonding, a bonding target can be bonded accurately and firmly.

Alternatively, the light-emitting element 21 may be bonded to the bottom plate 12 by the bonding member 73 such as the gold-tin solder. The melting temperature of the bonding member 73 is higher than the melting temperatures of the bonding members 71 and 72. Since bonding in the primary mounting of the light-emitting element 21 is naturally performed before sealing, the melting temperature of the bonding member 73 is set higher than those of the bonding members 71 and 72 used for sealing, secondary mounting, or the like. Oxygen is not required. Therefore, in this case, bonding can be performed in the absence of oxygen using the gold-tin solder or the like having a relatively high melting temperature within a range of not more than 300°C. The gold-tin solder has a melting temperature of from about 280°C to 300°C. This reliably ensures a difference in melting temperature relative to solder used for sealing. This can further reduce a risk that the light-emitting element 21 is displaced during sealing, secondary mounting, or the like.

The bonding members 71 to 73 used for the primary mounting, the secondary mounting, and the sealing may differ from one another at least in part in their components. Even when the bonding members are made of the same components, the melting temperatures can be made different by changing the component ratios. However, for such bonding members with different component ratios, partial melting of the bonding members may occur even at a temperature not more than the melting temperature. As a result, the positional relationship of the members bonded earlier may experience a shift or the like. Therefore, in the light-emitting device 1, use of bonding members containing different components allows mounting and sealing of components to be performed more firmly and accurately.

The above embodiments are illustrative examples, and various changes can be made.

For example, in the above description, the bottom plates 12 and 12c are each a heat transfer body separated from an electrical path. However, the configuration is not limited thereto. For example, the heat transfer body may also serve as a grounding surface.

The shape of the recess 10H is not limited to the above-described shape and may be another shape.

The GaN-based laser diode serving as the light-emitting element 21 may be a laser diode that emits light other than blue light. A plurality of GaN-based laser diodes may emit light of different wavelengths.

When a plurality of light-emitting elements is mounted on the substrate 50, each light-emitting element being accommodated in a separate package 10, some of the light-emitting elements need not be GaN-based laser diodes. In this case, when the package that accommodates the light-emitting element other than the GaN-based laser diode is sealed, bonding in the presence of oxygen need not be taken into consideration.

In the above description, the wiring line 111 has been described as including a via conductor; however, the wiring line 111 is not limited thereto. The wiring line 111 may include castellation or a side electrode.

Specific details, such as configurations, structures, positional relationships, and materials, described in the above embodiments may be appropriately changed without departing from the spirit of the present disclosure. The scope of the present invention encompasses the scope of the invention as set forth in the claims and equivalents thereof.

### INDUSTRIAL APPLICABILITY

The present disclosure can be used for a light-emitting device.

### REFERENCE SIGNS

1, 1a to 1c light-emitting device
10, 10c package
10H recess
11 frame body
111 wiring line
12, 12a, 12c bottom plate
121 protruding portion
15 connection electrode
21 light-emitting element
22 reflector
30, 30a lid
31 window portion
50 substrate
51 wiring line
52 base
70 to 73 bonding member
81 bonding wire

## Claims

1. A light-emitting device comprising:
a semiconductor laser element containing gallium nitride;
a housing including a recess in which the semiconductor laser element is located;
a lid sealing an open surface of the recess of the housing; and
a first bonding material bonding the lid and the housing,
wherein a member serving as a bottom surface of the recess is a heat transfer body,
oxygen is contained in the recess, and
the first bonding material melts at not more than 300°C in an oxygen-containing atmosphere.

2. The light-emitting device according to claim 1, further comprising:
a heat-dissipating body bonded to a lower surface of the housing; and
a second bonding material bonding the heat-dissipating body and the housing,
wherein the second bonding material melts at a temperature lower than a temperature at which the first bonding material melts.

3. The light-emitting device according to claim 1, further comprising:
a heat-dissipating body bonded to a lower surface of the housing; and
a second bonding material bonding the heat-dissipating body and the housing,
wherein the second bonding material melts at not more than 300°C and at a temperature higher than a temperature at which the first bonding material melts.

4. The light-emitting device according to claim 2 or 3, wherein the heat-dissipating body includes a metal-core printed circuit board.

5. The light-emitting device according to claim 2 or 3, wherein each of the first bonding material and the second bonding material is tin-silver-nickel solder, tin-silver-copper solder, tin-zinc solder, or tin-bismuth solder.

6. The light-emitting device according to any one of claims 1 to 5,
wherein the housing includes a wiring line electrically connected to the semiconductor laser element.

7. The light-emitting device according to any one of claims 1 to 6, wherein the semiconductor laser element is bonded to the recess with a conductive resin bonding material containing silver, copper, or gold.

8. The light-emitting device according to claim 2 or 3,
wherein the semiconductor laser element is bonded to the recess with a third bonding material, and
a melting temperature of the third bonding material is higher than melting temperatures of the first bonding material and the second bonding material.

9. The light-emitting device according to claim 8, wherein the first bonding material, the second bonding material, and the third bonding material differ from one another in their components at least in part.
